# EUROPÄISCHE PATENTSCHRIFT

(11) **EP 1 119 590 B1**
(45) Veröffentlichungstag und Bekanntmachung des Hinweises auf die Patenterteilung: **08.01.2003**
(21) Anmeldenummer: 99969425.0
(22) Anmeldetag: 09.09.1999
(51) Int. Cl.: C09B 47/26, G03F 7/004, C09D 11/00

(54) **SUBSTITUIERTE PHTHALOCYANINE**
SUBSTITUTED PHTHALOCYANINE
PHTHALOCYANINE SUBSTITUEE

(30) Priorität: 21.09.1998 CH 192298; 16.12.1998 EP 98811238; 29.12.1998 CH 258598; 09.02.1999 EP 99810107
(43) Veröffentlichungstag der Anmeldung: 01.08.2001
(73) Patentinhaber: Ciba Specialty Chemicals Holding Inc., 4057 Basel (CH)
(72) Erfinder: WOLLEB, Annemarie, CH-4232 Fehren (CH); WOLLEB, Heinz, CH-4232 Fehren (CH); DE KEYZER, Gerardus, CH-4125 Riehen (CH); WAGNER, Barbara, D-81739 München (DE)
(86) Internationale Anmeldenummer: EP9906653
(87) Internationale Veröffentlichungsnummer: WO00017275

(56) Entgegenhaltungen:
- EP-A- 0 519 395
- EP-A- 0 648 817
- EP-A- 0 719 847
- EP-A- 0 761 772
- WO-A-98/32802
- US-A- 4 000 158

## Beschreibung

Die Erfindung betrifft neue Phthalocyaninverbindungen und deren Verwendung als Farbmittel.

Phthalocyanine sind schon lange als Farbmittel bekannt, insbesondere als blaue Pigmente wie zum Beispiel C.I Pigment Blue 15 und Pigment Blue 16. Mit Substituenten kann die Farbe des Grundkörpers in gewissen Grenzen beeinflusst werden, wobei substituierte Produkte in der Regel schlecht definierte Gemische vieler Komponenten sind, deren Zusammensetzung und Farbe von den Herstellungsbedingungen stark abhängig sind.

Moderne Technologien verlangen jedoch immer mehr gut charakterisierte Farbmittel, deren Nuance möglichst reproduzierbar unter verschiedensten Bedingungen erzeugt werden kann. Dies ist insbesondere wichtig bei Farbmitteln, welche in einer gut löslichen latenten Form eingesetzt und erst danach in dessen endgültige pigmentäre Form überführt werden sollen.

Die bekannten substituierten Phthalocyanine erfüllen jedoch dieser Anforderung nicht im erwünschten Mass.

Aus WO98/14520 sind die selektive Herstellung formylierter und acylierter Phthalocyanine, sowie daraus erhältliche Produkte bekannt.

Aus EP 648 817 sind Phthalocyanine mit Alkoxycarbonylaminogruppen bekannt, welche direkt oder über eine C₁-C₄-1,1-Alkylen- oder Sulfongruppe am Phthalocyaninkern gebunden sind. In WO98/32802 sind verschiedene Verwendungsmöglichkeiten dafür offenbart.

WO98/32802 beschreibt die gut lösliche Verbindung der Formel 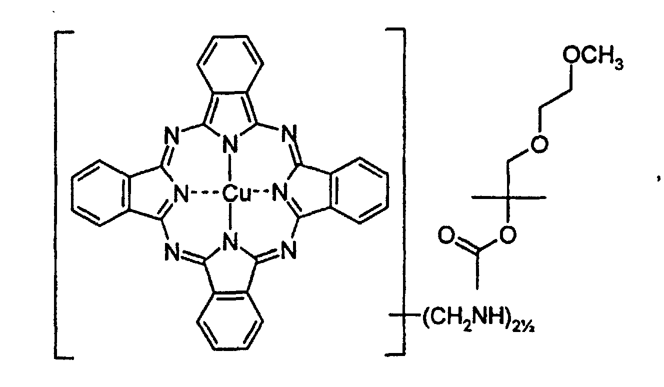 sowie deren thermische Zersetzung.

Es hat sich jedoch überraschend herausgestellt, dass diese latenten Phthalocyanine zu unerwarteten Schwierigkeiten im praktischen Einsatz führen können. Bei deren thermischer Zersetzung entstehen im Kontrast zu anderen Latentpigmenten unerwünschte Farbnuancen, und die Echtheiten sind nicht im gewünschten Masse zufriedenstellend. Dies ist speziell in hochwertigen Anwendungen, polychromen Systemen und insbesondere lichtempfindlichen Zusammensetzungen (Resists) ein Problem, wo hohe Anforderungen und ganz bestimmte Nuancen erreicht werden müssen, zum Beispiel in Farbfiltern.

US-3,972,904 beschreibt wasserlösliche Textilfarbstoffe, welche in üblichen hochwertigen, polychromen und lichtempfindlichen Zusammensetzungen jedoch nicht verwendet werden können.

Beispiel 8 von US-4,381,261 beschreibt die Herstellung der Verbindung der Formel 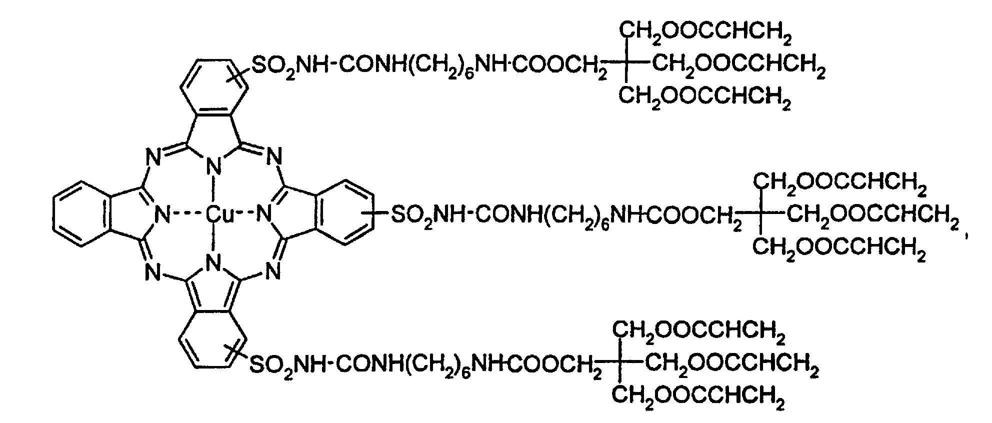 welche jedoch infolge ihrer hohen Viskosität in üblichen hochwertigen, polychromen und lichtempfindlichen Zusammensetzungen nicht verwendet werden kann.

US-4,000,158 beschreibt alkohol- und ketonlösliche Phthalocyaninverbindungen, welche wegen ihrer zu hohen Endlöslichkeit im Entwickler in üblichen lichtempfindlichen Zusammensetzungen nicht verwendet werden können.

Überraschend konnte diese Problemstellung mit den erfindungsgemässen Verbindungen gelöst werden.

Die Endung betrifft daher eine Verbindung der Formel 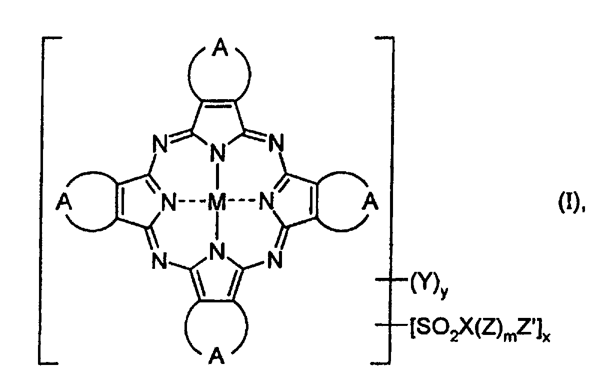 worin
- M: für ein divalentes Metall, Oxometall, Halogenometall oder Hydroxymetall oder 2 Wasserstoffatome steht,
- A: für einen Rest 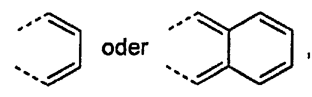 welches unsubstituiert oder durch Phenoxy, Naphthoxy, Phenylthio oder Naphthylthio substituiert sein kann,
- X: ein Heteroatom, ausgewählt aus der Gruppe bestehend aus N, O oder S bedeutet, wobei m wenn X gleich O oder S ist für die Zahl 0 und wenn X gleich N ist für die Zahl 1 steht,
- Y: einen beliebigen, gegenüber Alkylierungsreagenzien inerten Substituent bedeutet,
- Z: für Wasserstoff, Z' oder COOB steht,
- Z': für C₂-C₁₂Alkylen-N(COOB)₂, C₂-C₁₂Alkylen-NHCOOB, C₂-C₁₂Alkylen-OCOOB oder C₂-C₁₂Alkylen-SCOOB steht,
- x: eine Zahl von 1 bis 4, und y eine Zahl von 0 bis 15 sind,
wobei die Summe von x und y höchstens gleich 16 ist und gegebenenfalls je mehrere X, Y, Z und/oder Z' identisch oder unterschiedlich sein können, und
B für eine Gruppe der Formel 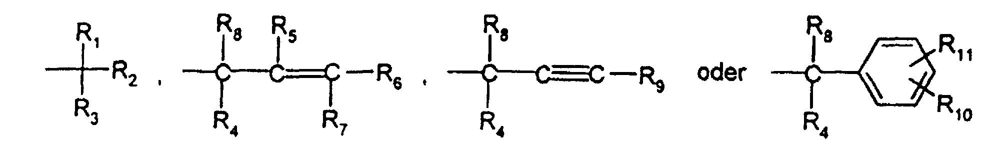 steht, worin
R₁ Wasserstoff oder C₁-C₆Alkyl,
R₂ und R₃ unabhängig voneinander C₁-C₆Alkyl bedeuten,
R₄ und R₈ unabhängig voneinander C₁-C₆Alkyl, durch O, S oder NR₁₂ unterbrochenes C₁-C₆Alkyl, unsubstituiertes oder durch C₁-C₆-Alkyl, C₁-C₆ Alkoxy, Halogen, Cyano oder Nitro substituiertes Phenyl oder Biphenyl bedeuten,
R₅, R₆ und R₇ unabhängig voneinander Wasserstoff oder C₁-C₆Alkyl bedeuten,
R₉ Wasserstoff, C₁-C₆Alkyl oder eine Gruppe der Formel 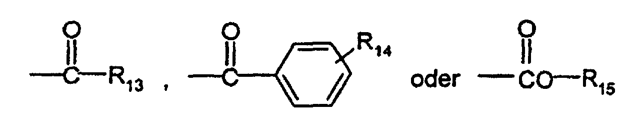 bedeutet,
R₁₀ und R₁₁ unabhängig voneinander Wasserstoff, C₁-C₆Alkyl, C₁-C₆Alkoxy, Halogen, Cyano, Nitro, N(R₁₂)₂ unsubstituiertes oder durch Halogen, Cyano, Nitro, C₁-C₆Alkyl oder C₁-C₆Alkoxy substituiertes Phenyl bedeuten,
R₁₂ und R₁₃ je C₁-C₆Alkyl, R₁₄ Wasserstoff oder C₁-C₆Alkyl und R₁₅ C₁-C₆Alkyl oder unsubstituiertes oder durch C₁-C₆Alkyl substituiertes Phenyl bedeuten,
C₂-C₁₂Alkylen ist zum Beispiel 1,2-Ethylen, 1,2-Propylen, 1,3-Propylen, 1,2-Butylen, 1,3-Butylen, 2,3-Butylen, 1,4-Butylen, 2-Methyl-1,2-propylen oder ein Isomer von Pentylen, Hexylen, Octylen, Decylen oder Dodecylen.
C₆-C₁₂Aryloxy ist O―C₆-C₁₂Aryl, beispielsweise Phenoxy oder Naphthoxy, bevorzugt Phenoxy.
C₁-C₆Alkylthio ist S―C₁-C₆Alkyl, bevorzugt S-C₁-C₄Alkyl.
C₆-C₁₂Arylthio ist S―C₆-C₁₂Aryl, beispielsweise Phenylthio oder Naphthylthio, bevorzugt Phenylthio.
C₂-C₁₂Dialkylamino ist N(Alkyl₁)(Alkyl₂), wobei die Summe der Kohlenstoffatome in den beiden Gruppen Alkyl₁ und Alkyl₂ von 2 bis 12 beträgt, bevorzugt N(C₁-C₄Alkyl)-C₁-C₄Alkyl.
C₇-C₁₈Alkylarylamino ist N(Alkyl₁)(Aryl₂), wobei die Summe der Kohlenstoffatome in den beiden Gruppen Alkyl₁ und Aryl₂ von 7 bis 18 beträgt, bevorzugt Methylphenylamino oder Ethylphenylamino.
C₁₂-C₂₄Diarylamino ist N(Aryl₁)(Aryl₂), wobei die Summe der Kohlenstoffatome in den beiden Gruppen Aryl₁ und Aryl₂ von 12 bis 24 beträgt, beispielsweise Diphenylamino oder Phenylnaphthylamino, bevorzugt Diphenylamino.
Gegenüber Alkyüerungsreagenzien inerte Substituenten sind zum Beispiel solche, welche unter den hiernach angegebenen Bedingungen mit Pyrokohlensäureestern nicht reagieren, beispielsweise solche, welche keine Hydroxy-, Amino- oder Thiolgruppen enthalten.

Die Substituenten SO₂X(Z)ₘZ' und Y können an irgend einem aromatischen Kohlenstoff der Reste A stehen, zum Beispiel an den peripheren Positionen eines Phthalocyanins oder Naphthalocyanins und/oder gegebenenfalls an einer beiliebigen Position der Phenoxy-, Naphthoxy-, Phenylthio- oder Naphtylthiosubstituenten.

Insbesondere kann es sich bei der Verbindung der Formel (I) um eine Verbindung der Formel 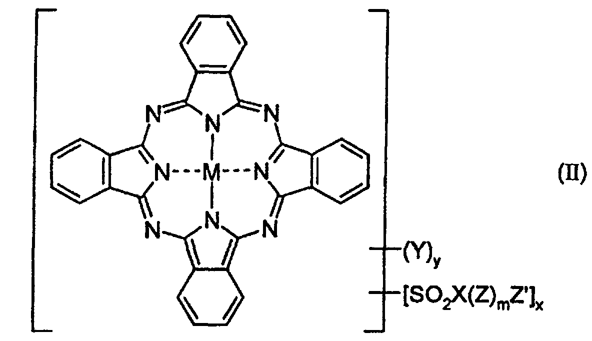 handeln.

In einer Verbindung der Formel (II) sind die Substituenten SO₂(Z)ₘZ' und Y zweckmässig an den peripheren Positionen der Phenylringe angebracht, bevorzugt an den äusseren Positionen (2, 3, 9, 10, 16, 17, 23 und/oder 24 gemäss Nomenklatur von Porphyrinen und Gallenpigmente / Mai 1989): 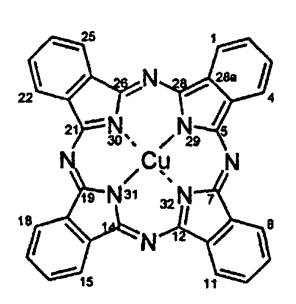
M ist bevorzugt Cu, Pd, Pb, Co, Ni, Zn, Mn oder V(=O).
A ist bevorzugt ein Rest 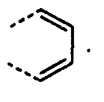
X ist bevorzugt N oder O, besonders bevorzugt N.
Y ist bevorzugt Cl oder Br.
Z ist bevorzugt H oder COOB, besonders bevorzugt COOB.
Z' ist bevorzugt C₂-C₁₂Alkylen-NHCOOB oder C₂-C₁₂Alkylen-OCOOB, besonders bevorzugt C₂-C₁₂Alkylen-OCOOB.
C₂-C₁₂Alkylen in Z' ist bevorzugt C₂-C₆Alkylen, besonders bevorzugt C₂-C₄Alkylen, ganz besonders bevorzugt 1,2-Ethylen.
y ist bevorzugt 0 oder 4 bis 8, besonders bevorzugt 0.

Die Summe von x und y ist bevorzugt höchstens gleich 8.
B ist bevorzugt eine Gruppe der Formel 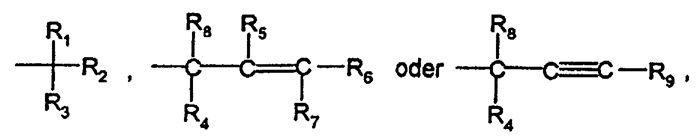 besonders bevorzugt 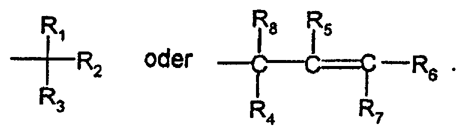 Insbesondere sind unter den definitionsgemässen Gruppen B diejenigen bevorzugt, welche bei anderen Latentpigmenten, zum Beispiel denjenigen aus EP 742 255, EP 761 772 oder WO98/32802, als bevorzugte Gruppen bekannt sind.
R₁ ist bevorzugt C₁-C₆Alkyl.

Die Verbindungen der Formel (I) können in Analogie zu an sich bekannten Methoden hergestellt werden, zum Beispiel ausgehend von bekannten sulfochlorierten Phthalocyaninen. Die sulfochlorierten Phthalocyanine selbst können in bekannter Weise durch Sulfochlorierung von Phthalocyaninen hergestellt werden. Femer sind sie auch erhältlich zum Beispiel durch Zyklisierung von 4-Sulfo-phthalsäure zu Phthalocyanin-tetrasulfonsäure und anschliessende Chlorierung mit Phosphorpentachlorid, so wie von K. Sakamoto in Dyes and Pigments 35, 375 (1997) und A. Hong in J. Phys. Chem. 91, 2109 (1987) offenbart, oder durch Zyklisierung von Sulfonamido-substituierten Phthalodinitrilen wie in Houben-Weyl E9d, 725 (1998 - Georg Thieme Verlag Stuttgart) offenbart. Gegebenenfalls können auch Mischsynthesen mit anderen Phthalodinitrilen erfolgen. Die sulfochlorierten Phthalocyanine können anschliessend mit Alkoholen, Thiolen oder Aminen zu den gewünschten Sulfonsäureestern beziehungsweise Sulfonamiden umgesetzt werden.

Bevorzugt werden die Verbindungen der Formel (I) in Analogie zu den beispielsweise in EP 648 770, EP 648 817, EP 654 711, EP 742 255, EP 761 772 und WO98/32802 beschriebenen Methoden hergestellt. Dazu wird ein Phthalocyanin der Formel (I), worin Z' für C₂-C₁₂Alkylen-OH, C₂-C₁₂Alkylen-SH oder C₂-C₁₂Alkylen-NH₂ steht, mit einem Pyrokohlensäurediester der Formel 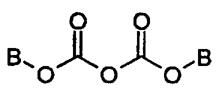 in einem aprotischen organischen Lösungsmittel in Gegenwart einer Base als Katalysator, zweckmässig bei Temperaturen zwischen 0 und 120°C, bevorzugt zwischen 10 und 100°C, während 2 bis 80 Stunden, umgesetzt.

Das jeweilige Molverhältnis richtet sich nach der Zahl der einzuführenden Reste B, wobei das Dicarbonat zweckmässig im Überschuss eingesetzt wird, bezogen auf die theoretisch notwendige Menge.

Phthalocyanine der Formel (I), worin Z' für C₂-C₁₂Alkylen-OH, C₂-C₁₂Alkylen-SH oder C₂-C₁₂Alkylen-NH₂ steht, können analog zu den oben angegebenen Methoden aus Phthalocyanin-sulfochloriden durch Umsetzung mit einem C₂-C₁₂Alkylen-diol, C₂-C₁₂Alkylendithiol, C₂-C₁₂Alkylen-diamin oder Hydroxy-C₂-C₁₂Alkylen-amin hergestellt werden.

Die erfindungsgemässen Verbindungen der Formel (I) eignen sich ausgezeichnet zum Färben von hochmolekularem organischem Material in der Masse.

Beispiele geeigneter hochmolekularer organischer Materialien, die mit den erfindungsgemässen Verbindungen der Formel (I) gefärbt werden können, sind Vinylpolymere, wie z.B. Polystyrol, Poly-α-methylstyrol, Poly-p-methylstyrol, Poly-p-hydroxystyrol, Poly-p-hydroxyphenylstyrol, Poly(methylacrylat) und Poly(acrylamid) sowie die entsprechenden Methacrylverbindungen, Poly(methylmaleat), Poly(acrylnitril), Poly(methacrylnitril), Poly(vinylchlorid), Poly(vinylfluorid), Poly(vinylidenchlorid), Poly(vinylidenfluorid), Poly(vinylacetat), Poly(methylvinylether) und Poly(butylvinylether); Novolake abgeleitet von C₁-C₆-Aldehyden, wie z.B. Formaldehyd und Acetaldehyd, und einem zweikemigen, vorzugsweise einkernigen Phenol, das gegebenenfalls mit einer oder zwei C₁-C₉-Alkylgruppen, einem oder zwei Halogenatomen oder einem Phenylring substituiert ist, wie beispielsweise o-, m- oder p-Kresol, Xylol, p-tert-Butylphenol, o-, m- oder p-Nonylphenol, p-Chlorphenol oder p-Phenylphenol, oder einer Verbindung mit mehr als einer phenolischen Gruppe, wie z.B. Resorcin, Bis-(4-hydroxyphenyl)methan oder 2,2-Bis-(4-hydroxyphenyl)propan; von Maleinimid und/oder Maleinanhydrid abgeleitete Polymere, wie z.B. Copolymere von Maleinanhydrid und Styrol; Poly(vinylpyrrolidon), Biopolymere und deren Derivate, wie z.B. Cellulose, Stärke, Chitin, Chitosan, Gelatine, Zein, Ethylcellulose, Nitrocellulose, Celluloseacetat und Cellulosebutyrat; natürliche Harze und Kunstharze, wie z.B. Gummi, Casein, Silikon und Silikonharze, ABS, Harnstoff- und Melamin-Formaldehydharze, Alkydharze, Phenolharze, Polyamide, Polyimide, Polyamid/imide, Polysulfone, Polyethersulfone, Polyphenylenoxide, Polyurethane, Polyharnstoffe, Polycarbonate, Polyarylene, Polyarylensulfide, Polyepoxide, Polyolefine und Polyalkadiene. Bevorzugte hochmolekulare organische Materialien sind z.B. Celluloseether und -ester, wie Ethylcellulose, Nitrocellulose, Celluloseacetat oder Cellulosebutyrat, natürliche Harze oder Kunstharze, wie Polymerisations- oder Kondensationsharze, wie Aminoplaste, insbesondere Harnstoff und Melamin-Formaldehydharze, Alkydharze, Phenoplaste, Polycarbonate, Polyolefine, Polystyrol, Polyvinylchlorid, Polyamide, Polyurethane, Polyester, ABS, Polyphenylenoxide, Gummi, Casein, Silikon und Silikonharze, einzeln oder in Mischungen.

Die erwähnten hochmolekularen organischen Verbindungen können einzeln oder in Gemischen als plastische Massen, Schmelzen oder in Form von Spinnlösungen, Lacken, Anstrichstoffen oder Druckfarben vorliegen. Je nach Verwendungszweck erweist es sich als vorteilhaft, die erfindungsgemässen Verbindungen der Formel (I) als Toner oder in Form eines Präparates einzusetzen.

Besonders geeignet sind die erfindungsgemässen Verbindungen der Formel (I) zum Massefärben von Polyvinylchlorid und insbesondere Polyolefinen, wie Polyethylen und Polypropylen, sowie von Lacken, auch von Pulverlacken, Druckfarben und Anstrichstoffen.

Bezogen auf das zu färbende hochmolekulare organische Material kann man die erfindungsgemässen Verbindungen der Formel (I) in einer Menge von 0,01 bis 30 Gew.%, vorzugsweise von 0,1 bis 10 Gew.%, einsetzen.

Die Einfärbung der hochmolekularen organischen Substanzen mit den erfindungsgemässen Verbindungen der Formel (I) erfolgt beispielsweise derart, dass man die Verbindung der Formel (I), gegebenenfalls in Form von Masterbatches, diesen Substraten unter Verwendung von Walzwerken, Misch- oder Mahlapparaten zumischt. Das gefärbte Material wird hierauf nach an sich bekannten Verfahren, wie Kalandrieren, Pressen, Strangpressen, Streichen, Giessen oder Spritzgiessen, in die gewünschte endgültige Form gebracht. Oft ist es erwünscht, zur Herstellung von nicht starren Formlingen oder zur Verringerung ihrer Sprödigkeit den hochmolekularen Verbindungen vor der Verformung sogenannte Weichmacher einzuverleiben. Als solche können z.B. Ester der Phosphorsäure, Phthalsäure oder Sebacinsäure dienen. Die Weichmacher können vor oder nach der Einverleibung der erfindungsgemässen Verbindungen der Formel (I) in die Polymeren eingearbeitet werden. Zwecks Erzielung verschiedener Farbtöne ist es ferner möglich, den hochmolekularen organischen Stoffen neben der erfindungsgemässen Verbindung noch Füllstoffe bzw. andere farbgebende Bestandteile, wie Weiss-, Bunt- oder Schwarzpigmente, in beliebigen Mengen zuzufügen.

Zum Einfärben von Lacken, Anstrichstoffen und Druckfarben werden die hochmolekularen organischen Materialien und die erfindungsgemässen Verbindungen der Formel (I) gegebenenfalls zusammen mit Zusatzstoffen, wie Füllmitteln, Pigmenten, Siccativen oder Weichmachern, in einem gemeinsamen organischen Lösungsmittel oder Lösungsmittelgemisch fein dispergiert bzw. gelöst. Man kann dabei so verfahren, dass man die einzelnen Komponenten für sich oder auch mehrere gemeinsam dispergiert bzw. löst, und erst hierauf alle Komponenten zusammenbringt.

In Färbungen, beispielsweise von Polyvinylchlorid oder Polyolefinen oder in Druckfarben, zeichnen sich die erfindungsgemässen Verbindungen der Formel (I) durch gute allgemeine Eigenschaften, wie gute Migrations-, Licht- und Wetterbeständigkeit aus.

Von ganz grosser Bedeutung ist die Umwandlung der in einem Substrat eingearbeiteten erfindungsgemässen Verbindungen zu den entsprechenden Verbindungen der Formel (I), worin Z' für C₂-C₁₂Alkylen-OH, C₂-C₁₂Alkylen-SH oder C₂-C₁₂Alkylen-NH₂ steht. Dies kann auf einfachste Weise erzielt werden, durch thermische Behandlung (Aufheizen auf Temperaturen zwischen 50 und 250°C, bevorzugt zwischen 100 und 200°C) der die erfindungsgemässen Verbindungen enthaltenden Festkörper, Lösungen oder Dispersionen in organischen oder wässrigen Medien, Polymerlösungen oder Schmelzen. In vielen Fällen kann die erwünschte Umwandlung bereits durch die üblichen Einarbeitungsbedingungen erreicht werden.

Dies erlaubt die Einfärbung von Lacken, Druckfarben, Kunststoffen, insbesondere auch in Faserform, wärmeempfindliche Registriersysteme, Tinten für den Tintenstrahldruck, Toner für elektrophotographische Aufzeichnungsverfahren, Farbbänder für den thermischen Transferdruck auf glatte oder gewobene Empfängersubstrate, sowie ganz speziell auch in lichtempfindlichen Zusammensetzungen, wie zum Beispiel negative oder positive Resist-Formulierungen, mit insgesamt verbesserten Eigenschaften, wie Reinheit, Farbton, Farbstärke, Brillianz, Transparenz und Echtheiten, sowie interessante Applikationen in der Analytik.

Weitere Gegenstände der Erfindung sind demnach ein hochmolekulares organisches Material enthaltend in der Masse ein in situ durch thermischen Abbau einer Verbindung der Formel (I) erzeugtes Farbmittel der Formel (I), worin Z' für C₂-C₁₂Alkylen-OH, C₂-C₁₂Alkylen-SH oder C₂-C₁₂Alkylen-NH₂ steht, sowie ein thermo-, photo- oder chemosensitives Aufzeichnungsmaterial, eine Tinte für den Tintenstrahldruck, ein Toner für elektrophotographische Aufzeichnungsverfahren, ein Farbband für den thermischen Transferdruck oder eine lichtempfindliche negative oder positive Resist-Zusammensetzung, dadurch gekennzeichnet, dass sie eine Verbindung der Formel (I) enthalten.

Tinten für den Tintenstrahldruck, Toner für elektrophotographische Aufzeichnungsverfahren, Farbbänder für den thermischen Transferdruck, thermo-, photo- und chemosensitive Aufzeichnungsmaterialien sowie lichtempfindliche negative oder positive Resist-Zusammensetzungen sind dem Fachmann bestens bekannt.

Ein ganz besonderer, überraschender Vorteil der erfindungsgemässen Verbindungen ist, dass deren thermische Umwandlung zu Produkten führt, deren Farbe dem für optische Anwendungen gewünschten, aber mit Phthalocyaninen bisher unerreichten Farbton Cyan (Blaugrün) entspricht. Die thermische Zersetzung der erfindungsgemässen Verbindungen führt zudem zu Produkte höherer Reinheit, als bei bisherigen Verbindungen.

Dank dieser verbesserten Eigenschaften können die erfindungsgemässen, löslichen Farbmittel der Formel (I) ganz besonders vorteilhaft in Zusammensetzungen verwendet werden, welche zur Herstellung von strukturierten Farbbildern oder Farbfiltern verwendet werden. Die Verwendung von löslichen Pigmentvorläufem zur Herstellung von strukturierten Farbbildern oder Farbfiltern ist aus EP 654 711 bekannt. Diese Zusammensetzungen enthalten zum Beispiel neben dem Farbmittel einen positiven oder negativen Resist. Resist-Formulierungen enthaltend Farbmittel der Formel (I) können im gewünschten Muster bestrahlt und entwickelt werden, wobei die thermische Umwandlung zu Farbmitteln der Formel (I), worin Z' für C₂-C₁₂Alkylen-OH, C₂-C₁₂Alkylen-SH oder C₂-C₁₂Alkylen-NH₂ steht, bereits bei der Bestrahlung oder Entwicklung, oder auch erst nachträglich erfolgen kann. Die Verbindungen der Formel (I) können auch durch Tintenstrahldruck oder thermisch induzierte Diffusion direkt im gewünschten Muster auf eine dazu geeignete Empfangsschicht appliziert werden. Die in EP 654 711 offenbarten Methoden eignen sich gut für die Herstellung von Farbfiltern.

Die Erfindung betrifft daher auch ein Verfahren zur Herstellung von strukturierten Farbbildern oder Farbfiltern, dadurch gekennzeichnet, dass ein positiver oder negativer Resist enthaltend ein Farbmittel der Formel (I) musterweise bestrahlt, entwickelt und thermisch behandelt wird, wobei die thermische Behandlung bei der Bestrahlung oder Entwicklung oder nachträglich erfolgen kann und die thermische Umwandlung zu einem Farbmittel der Formel (I) führt, worin Z' für C₂-C₁₂Alkylen-OH, C₂-C₁₂Alkylen-SH oder C₂-C₁₂Alkylen-NH₂ steht.

Die nachfolgenden Beispiele erläutern die Erfindung, ohne deren Umfang einzuschränken (wo nicht anders angegeben, handelt es sich bei "%" immer um Gewichts-%):
Beispiel A1: In einem 2,5 I-Kolben, versehen mit KPG-Rührer, Rückflusskühler, Innenthermometer, Tropftrichter und N₂-Überleitung, werden 86,5 mMol frisch hergestelltes Kupferphthalocyanin-tetrakis-sulfochlorid (hergestellt gemäss Beispiel 1 von WO98/45756, enthaltend 30% Kupferphthalocyanin-tris-sulfochlorid) in 1 Tetrahydrofuran (THF) gelöst. Zu dieser blauen Lösung werden 63,4 g Ethanolamin in 100 ml THF bei 10°C zugetropft. Die blaue Suspension wird 3 Stunden gerührt, dann während 17 Stunden rückflussiert, worauf das Lösungsmittel am Rotationsverdampfer bei 50°C unter Vakuum eingeengt wird. Der Rückstand wird mit 1 verdünnter Salzsäure (1 M) suspendiert und während 30 Minuten gerührt. Anschliessend wird filtriert, mit 750 ml Wasser gewaschen und über Nacht bei 50°C/160 mbar getrocknet. Es werden 77 g eines blauen Pulvers erhalten.

| Elementaranalyse [%]: (C_{39,4}H_{34,5}N_{11,7}O_{11,1}S_{3,7}Cu·1,3 H₂O) | | | | |
|---|---|---|---|---|
| theor. | C 44,85 | H 3,54 | N 15,53 | S 11,25 |
| gef. | C 45,10 | H 3,83 | N 15,46 | S 11,23 |

Benützt man das in Beispiel 1 von WO98/45756 angegebene Verfahren, verwendet aber weniger Chlorsulfonsäure, so kommt man leicht zu Gemischen von Verbindungen mit unterschiedlicher Anzahl Sulfogruppen, woraus sich die Verbindungen mit 1 bis 3 Sulfogruppen gewünschtenfalls mit üblichen Trennungsmethoden isolieren lassen. Diese Homologe oder Homologengemische können mit vergleichbaren Resultaten anstatt von Kupferphthalocyanin-tetrakis-sulfochlorid als Ausgangsmaterial verwendet werden.
Beispiel A2: In einem 1 I-Kolben, versehen mit KPG-Rührer, Innenthermometer, Tropftrichter und Stickstoffüberleitung werden 83,4 g Ethylendiamin in 100 ml THF gelöst. Zur gelblichen Lösung werden 17,36 mMol frisch hergestelltes Kupferphthalocyanin-tetrakis-sulfochlorid (hergestellt gemäss Beispiel 1 von WO98/45756, enthaltend 30% Kupferphthalocyanin-tris-sulfochlorid), gelöst in 280 ml THF, bei einer Innentemperatur von 20-25°C zugetropft. Das Reaktionsgemisch wird während 2½ Stunden gerührt. Dann wird das Lösungsmittel unter Vakuum bei 50°C am Rotationsverdampfer abdestilliert. Die dicke, blaugrüne Suspension wird mit 700 ml Aceton versetzt, während 15 Minuten gerührt, filtriert und mit Aceton gewaschen, bis das Filtrat farblos ist. Der Filterkuchen wird bei 50°C/160 mbar getrocknet, wobei 7 g eines blauen Pulvers erhalten werden.

| Elementaranalyse [%]: (C_{39,4}H_{38,2}N_{15,4}O_{7,4}S_{3,7}Cu·6 H₂O) | | | | |
|---|---|---|---|---|
| theor. | C 41,65 | H 4,45 | N 18,99 | S 10,44 |
| gef. | C 42,26 | H 4,62 | N 18,11 | S 9,84 |

Beissiel A3: In einem 1 I-Kolben, versehen mit KPG-Rührer, Innenthermometer, Tropftrichter und Stickstoffüberleitung werden 122,5 g 1,4-Diamino-butan in 100 ml THF gelöst. Zu dieser Lösung werden 17,36 mMol frisch hergestelltes Kupferphthalocyanin-tetrakis-sulfochlorid (hergestellt gemäss Beispiel 1 von WO98/45756, enthaltend 30% Kupferphthalocyanin-tris-sulfochlorid), gelöst in 280 ml THF, bei einer Innentemperatur von 20-25°C zugetropft. Das Reaktionsgemisch wird während 2½ Stunden gerührt. Dann wird das Lösungsmittel unter Vakuum bei 50°C am Rotationsverdampfer abdestilliert. Der blaue, ölige Rückstand wird mit 700 ml Aceton versetzt, während 15 Minuten gerührt, filtriert und mit Aceton gewaschen, bis das Filtrat farblos ist. Der Filterkuchen wird bei 50°C/160 mbar getrocknet, wobei 8,5 eines blauen Pulvers erhalten werden.

| Elementaranalyse [%]: (C_{46,6}H₅₃N_{15,4}O_{7,4}S_{3,7}Cu·5 H₂O) | | | | |
|---|---|---|---|---|
| theor. | C 45,92 | H 5,21 | N 17,66 | S 9,78 |
| gef. | C 46,25 | H 4,78 | N 16,45 | S 9,61 |

Beispiel A4: In einem 1 l-Kolben, versehen mit KPG-Rührer, Innenthermometer, Tropftrichter und Stickstoffüberleitung werden 103,43 g (0,89 Mol) 1,6-Diamino-hexan in 300 ml THF vorgelegt. Zu dieser Suspension werden 11,12 mMol frisch hergestelltes Kupferphthalocyanin-tetrakis-sulfochlorid (hergestellt gemäss Beispiel 1 von WO98/45756, enthaltend 30% Kupferphthalocyanin-tris-sulfochlorid), gelöst in 100 ml THF, bei einer Innentemperatur von 20-25°C zugetropft. Das Reaktionsgemisch wird während 1½ Stunden gerührt. Dann wird das Lösungsmittel unter Vakuum bei 50°C am Rotationsverdampfer abdestilliert. Der blaue, pastöse Rückstand wird mit 700 ml Aceton versetzt, während 15 Minuten gerührt, filtriert und mit Aceton gewaschen, bis das Filtrat farblos ist. Der Filterkuchen wird bei 50°C/160 mbar getrocknet, wobei 2,3 g eines blauen Pulvers erhalten werden.

| Elementaranalyse [%]: (C_{54,2}H_{67,8}N_{15,4}O_{7,4}S_{3,7}Cu · 6 H₂O) | | | | |
|---|---|---|---|---|
| theor. | C 48.45 | H 5,99 | N 16,05 | S 8,83 |
| gef. | C 47,94 | H 5,91 | N 15,29 | S 9,49 |

Beispiel A5: In einem 250 ml-Mehrhalskolben, versehen mit Rückflusskühler, Innenthermometer, Stickstoffüberleitung, KPG-Rührer und Heizpilz, werden 12,3 g 4-Sulfo-phthalsäure, 4,0 g Kupfer(II)chlorid, 1,0 g 1,8-Diazabicyclo[5.4.0]undec-7-en (DBU) und 30 g Harnstoff in 150 ml Trichlorbenzol vorgelegt. Die Reaktionslösung wird langsam auf 210°C erhitzt und anschliessend während 3 Stunden rückflussiert. Die blaue Suspension wird auf 23°C abgekühlt, filtriert und mit 400 ml Toluol gewaschen. Der Filterkuchen wird bei 60°C/160 mbar getrocknet und sogleich unter Argon mit 65,1 g Phosphorpentachlorid versetzt, auf 150°C erhitzt und während 24 Stunden bei dieser Temperatur gerührt. Anschliessend wird das überschüssige Phosphorpentachlorid unter Vakuum mittels einer Destillationsapparatur bei einer Badtemperatur von 120°C und einer Kopftemperatur von 55°C abdestilliert, wobei das Auffanggefäss mit Trockeneis gekühlt wird. Der Destillationsrückstand wird mit 500 ml Wasser versetzt, filtriert und mit 500 ml Wasser gewaschen. Der Filterkuchen wird in einem 500 ml-Kolben, versehen mit Rückflusskühler, Tropftrichter, Innenthermometer, Stickstoffüberleitung und KPG-Rührer, in 130 ml THF suspendiert und mit einer Lösung von 9,2 g Ethanolamin in 30 ml THF tropfenweise versetzt. Die dicke Suspension wird mit weiteren 100 ml THF verdünnt, auf Rückfluss erhitzt und während 20 Stunden gerührt. Anschliessend wird die blaue Suspension auf 23°C abgekühlt und das Lösungsmittel abdekantiert. Der Rückstand wird mit 200 ml Wasser versetzt und während 30 Minuten gerührt. Die Suspension wird filtriert, mit 200 ml Wasser gewaschen und bei 50°C/160 mbar getrocknet, worauf 6,3 g eines blauen Pulvers erhalten werden.
Beispiel A6: 105 ml Chlorsulfonsäure werden zu 25,0 g Kupfer-phthalocyanin getropft, wobei die Temperatur unter Kühlung mit einem Eisbad auf maximal 50°C gehalten wird. Dann wird innert 45 Minuten auf 145°C aufgeheizt. Nach 3½ Stunden wird auf 80°C gekühlt, dann innert 25 Minuten portionsweise mit insgesamt 32,5 ml Thionylchlorid versetzt. Nach 3½ Stunden bei 80-85°C und 16 Stunden bei 23°C wird das Reaktionsgemisch auf 4 I Eiswasser ausgetragen. Das ausgefallene Produkt wird abfiltriert, mit 4 I Eiswasser gewaschen und 30 Minuten an der Luft getrocknet.
Die erhaltene blaue Paste wird in 200 ml in Tetrahydrofuran gelöst. Eine Lösung von 60 ml Ethanolamin in 200 ml Tetrahydrofuran wird innert 45 Minuten unter Kühlung auf 30°C zugetropft. Das Reaktionsgemisch wird dann 16 Stunden zum Rückfluss erhitzt, auf 23°C abgekühlt und unter vermindertem Druck eingedampf. Nach Zugabe von 1,5 I verdünnter Salzsäure (0.5 M) wird der Niederschlag abfiltriert, mit 0.5 I verdünnter Salzsäure gewaschen und bei 95°C / 130 mbar eingedampft. Man bekommt 42,0 g des erwünschten Pigments.

| Analyse [%]: (C₄₀H₃₆N₁₂O₁₂S₄Cu·4 H₂O) | | | | | | |
|---|---|---|---|---|---|---|
| theor. | C 43,18 | H 3,70 | N 15,11 | S 11,53 | Cu 5,71 | H₂O 4,00 |
| gef. | C 43,38 | H 3,64 | N 14,65 | S 10,99 | Cu 5,65 | H₂O 3,96 |

Beispiel A7: Man verfährt analog zu Beispiel A6, verwendet aber Kobalt-phthalocyanin anstatt von Kupfer-phthalocyanin.
Beiseiel A8: Man verfährt analog zu Beispiel A6, verwendet aber Zink-phthalocyanin anstatt von Kupfer-phthalocyanin.
Beispiel A9: Man verfährt analog zu Beispiel A6, verwendet aber Kupfer-naphthalocyanin anstatt von Kupfer-phthalocyanin.
Beispiel A10: Man verfährt analog zu Beispiel A6, verwendet aber ein Pentakis-Chlor-kupferphthalocyanin-Isomerengemisch anstatt von Kupfer-phthalocyanin.
Beispiel A11: Man verfährt analog zu Beispiel A5, verwendet aber 3-Phenoxy-phthalsäure anstatt von 4-Sulfo-phthalsäure. UV/VIS (CH₂Cl₂): λₘₐₓ = 723 nm.
Beispiel A12: Man verfährt analog zu Beispiel A10, verwendet aber 3-(β-Naphthoxy)-phthalsäure anstatt von 3-Phenoxy-phthalsäure. UV/VIS (CH₂Cl₂): λₘₐₓ = 715 nm.
Beispiel A13: Man verfährt analog zu Beispiel A11, verwendet aber 3-Phenylthio-phthalsäure anstatt von 3-Phenoxy-phthalsäure.
Beispiel A14: Man verfährt analog zu Beispiel A12, verwendet aber 3-(β-Naphthylthio)-phthalsäure anstatt von 3-(β-Naphthoxy)-phthalsäure.
Beispiel B1: In einem 2,5 I-Kolben, versehen mit Tropftrichter und N₂-Überleitung, werden 154 g der Verbindung aus Beispiel A1 in 1,5 I THF vorgelegt und mittels KPG-Rührer während 19 Stunden gerührt. Dann werden 23 g 60%iges Natriumhydrid portionsweise zugegeben und erneut während 24 Stunden bei 23°C gerührt. Anschliessend werden 314,52 g Di-tert.-butyldicarbonat in 300 ml THF zugetropft und die Suspension während 24 Stunden bei 23°C gerührt. Die Lösung wird 65 Stunden stehen gelassen. Das Reaktionsgemisch wird anschliessend durch einen Stofffilter filtriert und das Filtrat bei 40° C unter Vakuum am Rotationsverdampfer eingeengt. Der blaue, pastöse Rückstand wird in 1 l Hexan aufgeschlämmt, filtriert und der Rückstand mit Hexan gewaschen. Der pulverförmige Filterkuchen wird in THF aufgenommen und mit THF als Laufmittel über Kieselgel filtriert. Das Filtrat wird bei 40°C unter Vakuum eingeengt, wobei 63 g eines blauen, feuchten Feststoffes erhalten werden, der in 500 ml Hexan supendiert wird. Es wird erneut filtriert, mit Hexan gewaschen und über Nacht bei 23°C/160 mbar getrocknet. Es werden 40 g eines blauen Pulvers erhalten.

| | | | | | | | |
|---|---|---|---|---|---|---|---|
| Elementaranalyse [%] | theor. | C 49,06 | H 4,67 | N 11,44 | S 8,73 | O 21,78 | Cu 4,33 |
| | gef. | C 49,57 | H 4,90 | N 11,62 | S 8,19 | O 21,02 | Cu 5,02 |

TGA (Aufheizrate 10°C/Min): Wendepunkt der Zersetzung = 160°C; es bildet sich das Produkt gemäss Beispiel A1 zurück.
UV/VIS (NMP): λₘₐₓ = 672 nm, ε = 178544.
Beispiel B2: In einem 250 ml Mehrhalskolben werden unter Argon 7 g der Verbindung aus Beispiel A2 in 100 ml THF vorgelegt und während 24 Stunden gerührt. Anschliessend werden 0,32 g N,N-Dimethyl-4-aminopyridin (DMAP) und nach weiteren 5 Stunden 17,2 g Di-tert.-butyldicarbonat zugegeben. Die Suspension wird während 21 Stunden bei 23°C gerührt. Dann wird über Celite filtriert, mit THF gewaschen und das Filtrat unter Vakuum bei 40°C eingeengt. Der blaue Rückstand wird in 30 ml Dichlormethan gelöst, mit 15 ml Diethylether versetzt und tropfenweise auf 300 ml Hexan gegeben, worauf die entstandene Suspension filtriert und mit Hexan gewaschen wird. Der blaue Filterkuchen wird in THF gelöst und mit THF als Laufmittel durch Kieselgel filtriert. Das Lösungsmittel wird unter Vakuum bei 40°C am Rotationsverdampfer abdestilliert. Der blaue Rückstand wird in Hexan suspendiert, filtriert und über Nacht bei 23°C/160 mbar getrocknet. Es werden 2,8 g eines blauen Pulvers erhalten.
TGA (Aufheizrate 10°C/Min): Wendepunkt der Zersetzung = 166°C; es bildet sich das Produkt gemäss Beispiel A2 zurück.
UV/VIS (NMP): λₘₐₓ = 673 nm, ε = 88634.
Beispiel B3: In einem 250 ml Mehrhalskolben werden unter Argon 8,5 g der Verbindung aus Beispiel A3 in 110 ml THF vorgelegt und während 24 Stunden gerührt. Dann werden 0,35 g DMAP und nach weiteren 5 Stunden 18,9 g Di-tert.-butyldicarbonat zugegeben. Die Suspension wird während 19 Stunden bei 23°C gerührt. Anschliessend wird über Celite filtriert, mit THF gewaschen und das Filtrat unter Vakuum bei 40°C eingeengt. Der blaue Rückstand wird in THF gelöst und mit THF als Laufmittel durch Kieselgel filtriert. Das Lösungsmittel wird unter Vakuum bei 40°C am Rotationsverdampfer abdestilliert. Der blaue Rückstand wird in 15 ml Dichlormethan gelöst, mit 7 ml Diethylether versetzt und tropfenweise auf 200 ml Hexan gegeben, worauf die entstandene Suspension filtriert und mit Hexan gewaschen wird. Der Filterkuchen wird bei 23°C/160 mbar getrocknet. Es werden 1,3 g eines blauen Pulvers erhalten.
TGA (Aufheizrate 10°C/Min): Wendepunkt der Zersetzung = 166°C; es bildet sich das Produkt gemäss Beispiel A3 zurück.
UV/VIS (NMP): λₘₐₓ = 673 nm, ε = 89510.
Beispiel B4: In einem 250 ml Mehrhalskolben werden unter Argon 2,2 g der Verbindung aus Beispiel A4 in 30 ml THF vorgelegt und während 8 Stunden gerührt. Anschliessend werden 83 mg DMAP und 4,47 g Di-tert.-butyldicarbonat zugegeben. Die Suspension wird während 17 Stunden gerührt. Dann wird mit THF als Laufmittel durch Kieselgel filtriert und das Lösungsmittel unter Vakuum bei 40°C am Rotationsverdampfer abdestilliert. Der blaue Rückstand wird in 200 ml Hexan suspendiert, filtriert, mit Hexan gewaschen und bei 23°C/160 mbar über Nacht getrocknet. Da das TGA auf eine unreine Substanz hinweist, wird das blaue Pulver in 3 ml Dichlormethan aufgenommen, mit 1,5 ml Diethylether versetzt und tropfenweise auf 30 ml Hexan gegeben. Anschliessend wird filtriert und bei 23°C/160 mbar getrocknet. Es werden 0,4 g eines blauen Pulvers erhalten.

| | | | | | |
|---|---|---|---|---|---|
| Elementaranalyse [%] | theor. | C 54,03 | H 6,20 | N 13,26 | S 7,59 |
| | gef. | C 53,08 | H 5,77 | N 12,25 | S 7,38 |

TGA (Aufheizrate 10°C/Min): Wendepunkt der Zersetzung = 168°C; es bildet sich das Produkt gemäss Beispiel A4 zurück.
UV/VIS (NMP): λₘₐₓ = 672 nm, ε = 98871.
Beispiel B5: 20,0 g der Verbindung aus Beispiel A6 werden in einem 1,5 I Reaktionsgefäss, das mit einem Rührer, Thermometer und einem Stickstoffzugang versehen ist, mit 2,7 g Dimethylaminopyridin, 500 ml Tetrahydrofuran und 40 ml Pyridin unter kräftigem Rühren suspendiert. Bei 23°C werden 41.0 g di-t-Butylpyrocarbonat zugegeben. Die Reaktionsmischung wird 20 Stunden weitergerührt, anschliessend bei 23°C / 200 mbar bis auf ein Volumen von zirka 50 ml eingeengt. Durch Zugabe von 1 l n-Hexan wird ein dunkelblauer Niederschlag ausgefällt, der abfiltiert und portionenweise mit insgesamt 1 l n-Hexan gründlich gewaschen wird. Der Filterrückstand wird in 600 ml Tetrahydrofuran gelöst. Die Lösung wird durch 50 g Kieselgel filtriert, wobei der Kieselgel mit 500 ml Tetrahydrofuran nachgespült wird. Nach Einengen des Filtrats bei 23°C / 200 mbar wird der Rückstand in 500 ml n-Hexan aufgenommen und abfiltriert. Der Rückstand wird abfiltiert, mit n-Hexan gewaschen und bei 23°C / 20 mbar getrocknet. Man bekommt 26,6 g eines reinen, kobaltblauen Pulvers der angenommenen Formel: 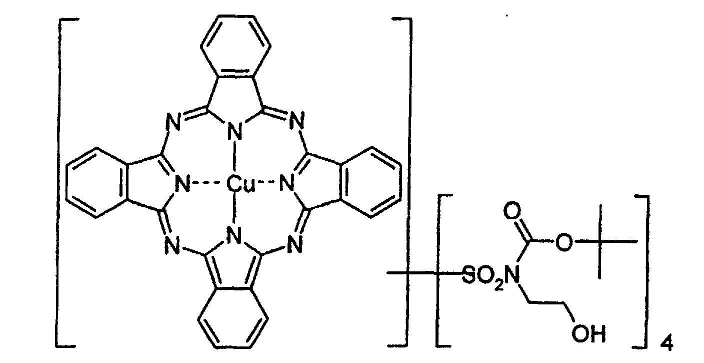
Beispiel B6: Analog zu Beispiel B5 erhält man aus dem Produkt gemäss Beispiel A7 das Produkt folgender Struktur:

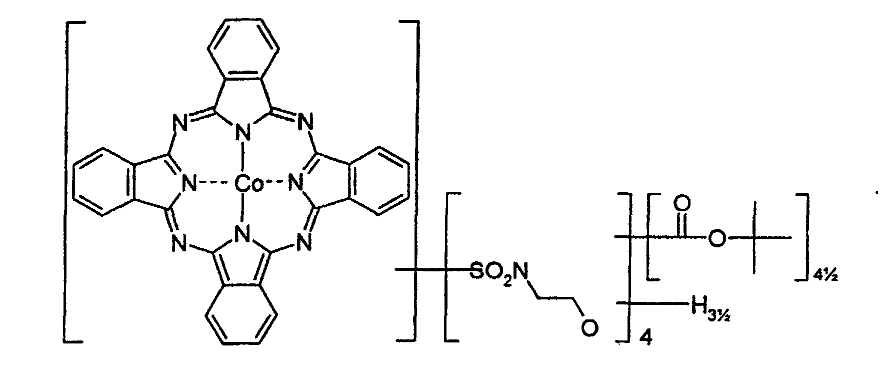

| Analyse [%]: (C₆₅H₇₆N₁₂O₂₂S₄Co) | | | | | |
|---|---|---|---|---|---|
| theor. | C 49,90 | H 4,90 | N 10,74 | S 8,20 | Co 3,77 |
| gef. | C 49,08 | H 4,66 | N 11,20 | S 6,86 | Co 3,39. |

| Thermogravimetrische Analyse (0-400°C, 10°C/Min): | | | |
|---|---|---|---|
| theor. | Gewichtsverlust | 32,0 % | |
| gef. | Gewichtsverlust | 30,1 % | (Max. bei 158°C) |

Beispiel B7: Analog zu Beispiel B5 bekommt man aus dem Produkt gemäss Beispiel A9 das Produkt folgender Struktur in guter Ausbeute: 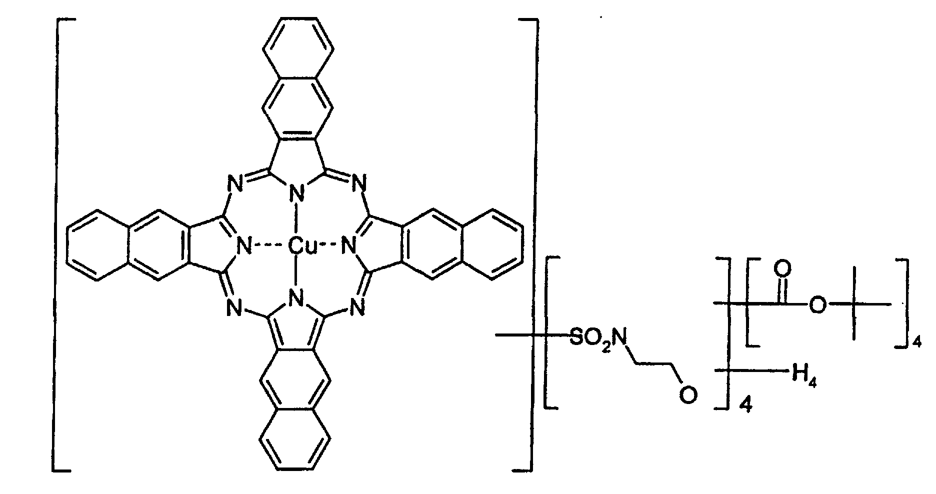 Thermogravimetrische Analyse (0-400°C, 10°C/min): Maximum bei 159°C.
Beissiel B8: Einer Suspension von 5,0 g der Verbindung aus Beispiel A6 in 140 ml Tetrahydrofuran werden 0,66 g 4-Dimethylaminopyridin und 11,4 g Di-tert.-butyl-pyrocarbonat zugegeben; das Reaktionsgemisch wird 16 Stunden bei 23°C gerührt, über 40 g Hyflo Super-Cel®, dann über 140 g Kieselgel filtriert. Nach dem Nachwaschen der Filter mit 600 ml Tetrahydrofuran wird die Lösung unter vermindertem Druck eingedampft. Das Produkt wird mit 500 ml n-Hexan gefällt, abfiltriert, mit n-Hexan nachgewaschen und bei 20°C/130 mbar getrocknet. Man erhält 7,4 g eines blauen Pulvers folgender Struktur:

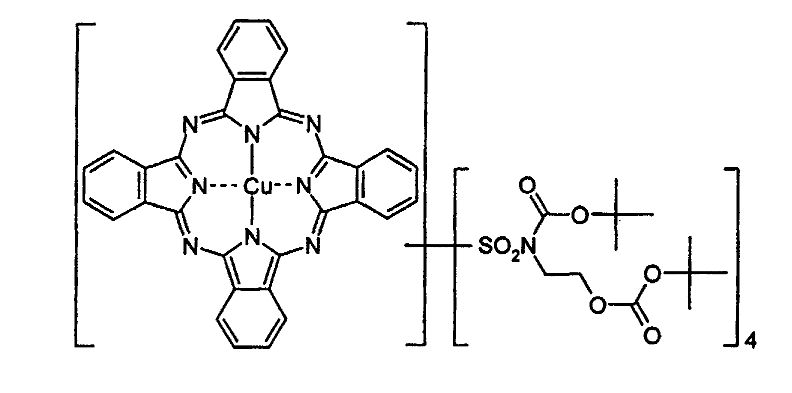

| Analyse [%]: (C₈₀H₁₀₀N₁₂O₂₈S₄Cu · 0.5 H₂O) | | | | | | |
|---|---|---|---|---|---|---|
| theor. | C 51,15 | H 5,42 | N 8,95 | S 6,83 | Cu 3,38 | H₂O 0,48 |
| gef. | C 50,92 | H 5,04 | N 9,66 | S 7,00 | Cu 3,59 | H₂O 0,48. |

UV/VIS (CH₂Cl₂): λₘₐₓ = 672 nm (ε = 140500).

| Thermogravimetrische Analyse (0-400°C, 10°C/Min): | | |
|---|---|---|
| theor. | Gewichtsverlust | 42,8 % |
| gef. | Gewichtsverlust | 42,1 % (Max. bei 177°C) |

Beispiel B9: Analog zu Beispiel B8 bekommt man aus dem Produkt gemäss Beispiel A10 das Produkt folgender Struktur in quantitativer Ausbeute:

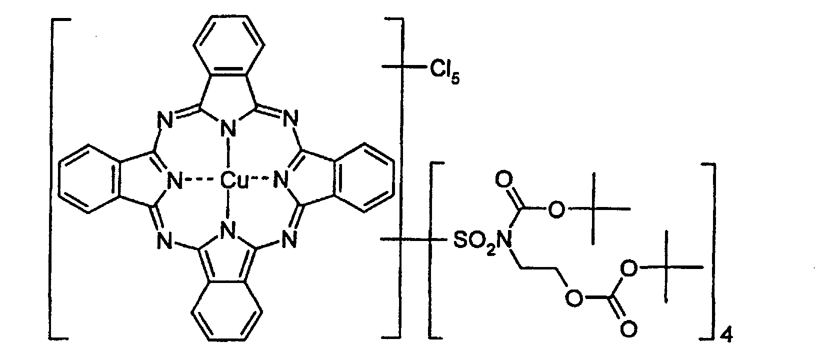

| Analyse (%]: (C_{79,4}H_{100,5}Cl₅N_{15,4}O_{29,1}S_{3,7}Cu · 1,6 H₂O) | | | | | | | |
|---|---|---|---|---|---|---|---|
| th. | C 44,89 | H 4,92 | N 10,15 | S 5,58 | Cu 2,99 | Cl 8,34 | H₂O 1,6 |
| gef. | C 45,61 | H 4,58 | N 10,29 | S 6,72 | Cu 3,15 | Cl 9,14 | H₂O 1,6 |

UV/VIS (CH₂Cl₂): λₘₐₓ = 676 nm (ε = 75363).
Thermogravimetrische Analyse (0-400°C, 10°C/min): Maximum bei 168°C.
Beispiel B10: Analog zu Beispiel B8 bekommt man aus dem Produkt gemäss Beispiel A11 das Produkt folgender Struktur (Isomerengemisch): 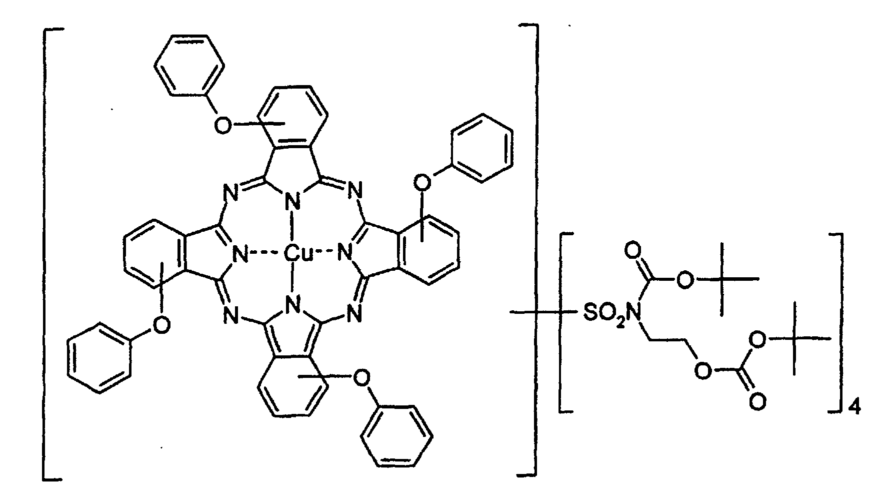 UV/VIS (CH₂Cl₂): λₘₐₓ = 725 nm (ε = 59507).
Thermogravimetrische Analyse (0-400°C, 10°C/min): Maximum bei 176°C.
Beispiel B11: Analog zu Beispiel B10 bekommt man aus dem Produkt gemäss Beispiel A12 das Produkt folgender Struktur: 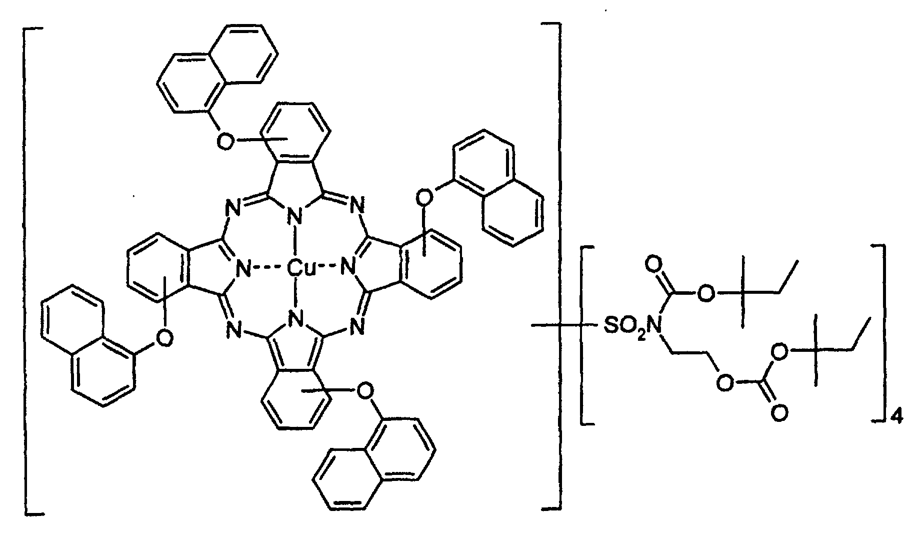 UV/VIS (CH₂Cl₂): λₘₐₓ = 715 nm (ε = 32644).
Thermogravimetrische Analyse (0-400°C, 10°C/min): Maximum bei 185°C.
Beispiel B12: Analog zu Beispiel B10 bekommt man aus dem Produkt gemäss Beispiel A13 der entsprechende Thioether.
Beispiel B13: Analog zu Beispiel B11 bekommt man aus dem Produkt gemäss Beispiel A14 der entsprechende Thioether.
Beispiel B14: Analog zu Beispiel B8 bekommt man mit Di-tert.-amyl-pyrocarbonat das Produkt folgender Struktur in guter Ausbeute: 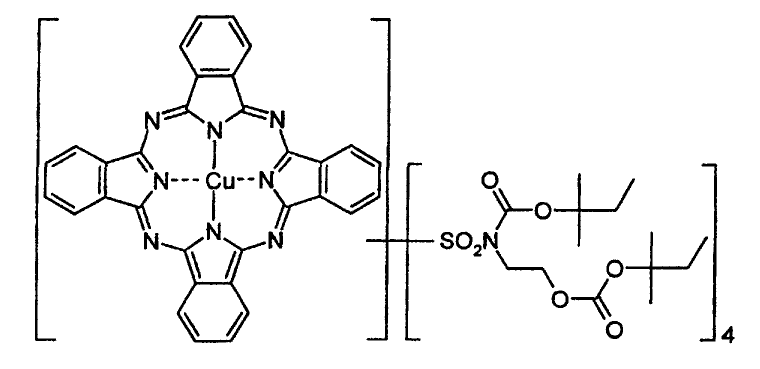 UV/VIS (CH₂Cl₂): λₘₐₓ = 672 nm (ε = 110205).
Thermogravimetrische Analyse (0-400°C, 10°C/min): Maximum bei 177°C.
Beispiel B15: Analog zu Beispiel B8 bekommt man aus dem Produkt gemäss Beispiel A8 das Produkt folgender Struktur in guter Ausbeute:

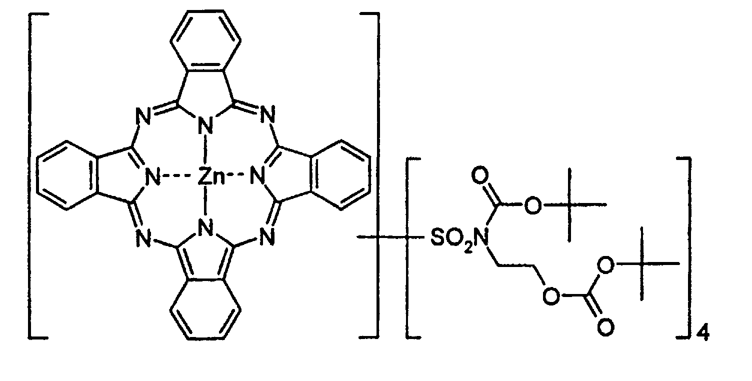

| Analyse [%]: (C₈₀H₁₀₀N₁₂O₂₈S₄Zn) | | | | | | |
|---|---|---|---|---|---|---|
| th. | C 50,86 | H 5,44 | N 8,90 | S 6,79 | Zn 3,46 | H₂O 0,94 |
| gef. | C 51,51 | H 5,19 | N 10,06 | S 6,79 | Zn 3,02 | H₂O 0,94. |

UV/VIS (CH₂Cl₂): λₘₐₓ = 674 nm (ε = 152876).
Thermogravimetrische Analyse (0-400°C, 10°C/min): Maximum bei 177°C.
Beissiel C1: Eine Formulierung wird hergestellt durch Auflösung von 1,24 g ™PHM-C Resin (Maruka Lyncur, M_{w} = 5300), 0,25 g ™Cymel 300 (Cyanamid, doppelt destilliert), 0,055 g ™Triazine A (Produits Chimiques Auxifiaires et de Synthese, Longjumeau, France) und 0,5 g des solubilisierten Pigments gemäss Beispiel B1 in 7,5 g Cyclopentanon (™OMM HTR-2D, Olin Micro-electronic Materials, Zwijndrecht, Belgie). Nach einer Filtration durch einen 1,0 µm-Filter wird die Lösung auf eine 3,81 x 3,81 cm grosse Glasplatte (Corning Typ 1737) bei einer Umdrehungszahl von 1000 U/min aufgeschleudert und dann auf einer Wärmeplatte bei 100°C während 2 Minuten getrocknet. Die Schichtdicke beträgt etwa 1,5 µm. Dieser Film wird durch eine Maske mittels einer ™UXM-502 MD Lampe (500 W, Ushio) während 66,7 s bildmässig belichtet (= 100 mJ/cm²) und anschliessend auf der Wärmeplatte während 2 Minuten bei 100°C erhitzt. Danach wird während 25 s mit einer wässerigen Lösung enthaltend 2,38 Gew-% Tetramethylammoniumhydroxid und 1 Gew-% Triton® X-100 (Fluka Chemie AG, Buchs, Schweiz) entwickelt, wobei die zuvor belichteten Zonen des Films zurückbleiben, die unbelichteten Zonen dagegen weggelöst werden. Schliesslich wird die strukturierte Glasplatte während 2 Minuten mit Wasser gespült, mit Luft getrocknet und während 5 Minuten auf 200°C erhitzt. Man erhält gemusterte Filmstrukturen einer tiefblauen Farbe. Die Farbkoordinaten, gemessen mit einer Standardlichtquelle F10, betragen:
x = 0,209 ; y = 0,326 ; Y = 46,5 %.
Beispiel C2: Eine Formulierung wird hergestellt durch Auflösung von 0,25 g ™PHM-C Resin (Maruka Lyncur, M_{w} = 5300), 0,06 g ™Cymel 300 (Cyanamid, doppelt destilliert), 0,01 g ™Triazine A (Produits Chimiques Auxiliaires et de Synthese, Longjumeau, France) und 0,10 g des solubilisierten Pigments gemäss Beispiel B6 in 0,95 g Cyclopentanon (™OMM HTR-2D, Olin Micro-electronic Materials, Zwijndrecht, Belgie). Nach einer Filtration durch einen 0,45 µm-Filter wird die Lösung auf eine 3,81 x 3,81 cm grosse Glasplatte (Corning Typ 1737) bei einer Umdrehungszahl von 1000 U/min aufgeschleudert und dann auf einer Wärmeplatte bei 100°C während 1 Minuten getrocknet. Diese Schicht hat einen Absorptionsmaximum (λₘₐₓ) bei 669 nm. Nach 5 Minuten bei 200°C liegt der Absorptionsmaximum (λₘₐₓ) bei 662 nm.

## Patentansprüche

1. Verbindung der Formel 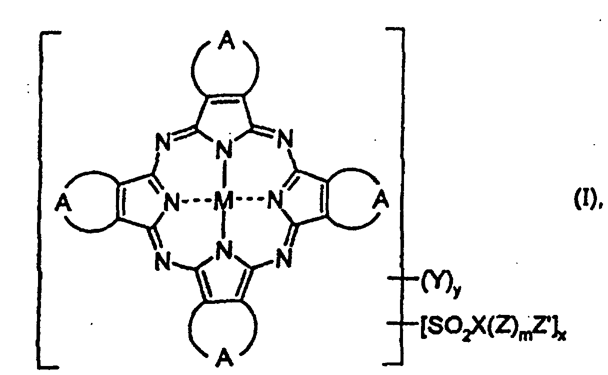 worin
M für ein divalentes Metall, Oxometall, Halogenometall oder Hydroxymetall oder 2 Wasserstoffatome steht,
A für einen Rest 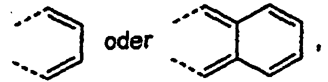 welcher unsubstituiert oder durch Phenoxy, Naphthoxy, Phenylthio oder Naphthylthio substituiert sein kann,
X ein Heteroatom, ausgewählt aus der Gruppe bestehend aus N, O oder S bedeutet, wobei m wenn X gleich O oder S ist für die Zahl 0 und wenn X gleich N ist für die Zahl 1 steht,
Y einen beliebigen, gegenüber Alkylierungsreagenzien inerten Substituent bedeutet,
Z für Wasserstoff, Z' oder COOB steht,
Z' für C₂-C₁₂Alkylen-N(COOB)₂, C₂-C₁₂Alkylen-NHCOOB, C₂-C₁₂Alkylen-OCOOB oder C₂-C₁₂Alkylen-SCOOB steht,
x eine Zahl von 1 bis 4, und y eine Zahl von 0 bis 15 sind,
wobei die Summe von x und y höchstens gleich 16 ist und gegebenenfalls je mehrere X, Y, Z und/oder Z' identisch oder unterschiedlich sein können, und
B für eine Gruppe der Formel 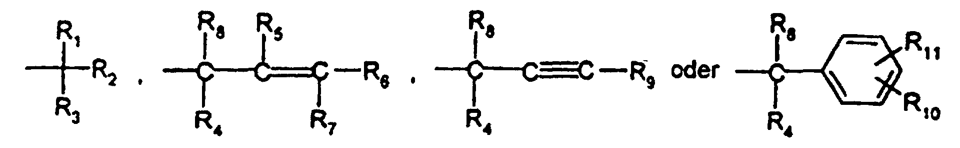 steht, worin
R₁ Wasserstoff oder C₁-C₆Alkyl,
R₂ und R₃ unabhängig voneinander C₁-C₆Alkyl bedeuten,
R₄ und R₈ unabhängig voneinander C₁-C₆Alkyl, durch O, S oder NR₁₂ unterbrochenes C₁-C₆Alkyl, unsubstituiertes oder durch C₁-C₆-Alkyl, C₁-C₆-Alkoxy, Halogen, Cyano oder Nitro substituiertes Phenyl oder Biphenyl bedeuten,
R₅, R₆ und R₇ unabhängig voneinander Wasserstoff oder C₁-C₆Alkyl bedeuten,
R₉ Wasserstoff, C₁-C₆Alkyl oder eine Gruppe der Formel 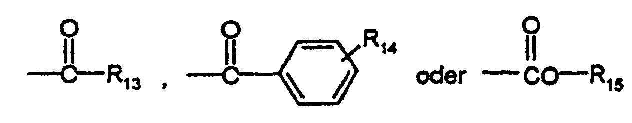 bedeutet,
R₁₀ und R₁₁ unabhängig voneinander Wasserstoff, C₁-C₆Alkyl, C₁-C₆Alkoxy, Halogen, Cyano, Nitro, N(R₁₂)₂ unsubstituiertes oder durch Halogen, Cyano, Nitro, C₁-C₆Alkyl oder C₁-C₆Alkoxy substituiertes Phenyl bedeuten,
R₁₂ und R₁₃ je C₁-C₆Alkyl, R₁₄ Wasserstoff oder C₁-C₆Alkyl und R₁₅ C₁-C₆Alkyl oder unsubstituiertes oder durch C₁-C₆Alkyl substituiertes Phenyl bedeuten,

2. Verbindung gemäss Anspruch 1 der Formel 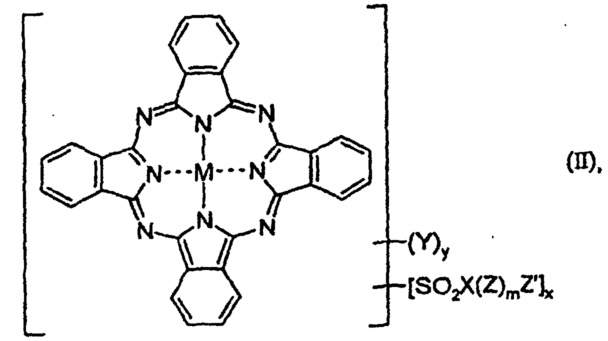 worin Y,X,Z,Z',y,M, x und m die in Anspruch 1 gegebene Bedeutung haben.

3. Verbindung gemäss Anspruch 1, worin M für Cu, Pd, Pb, Co, Ni, Zn, Mn oder V(=O) steht.

4. Verbindung gemäss Anspruch 1, worin X für N oder O und Z' für C₂-C₁₂Alkylen-NHCOOB oder C₂-C₁₂Alkylen-OCOOB stehen.

5. Verbindung gemäss Anspruch 1, worin X für N, Z für COOB und Z' für C₂-C₁₂Alkylen-OCOOB stehen.

6. Verbindung gemäss Anspruch 1, worin Z' für C₂-C₆Alkylen-N(COOB)₂, C₂-C₆Alkylen-NHCOOB, C₂-C₆-Alkylen-OCOOB oder C₂-C₆-Alkylen-SCOOB steht.

7. Verbindung gemäss Anspnrch 1, worin B für 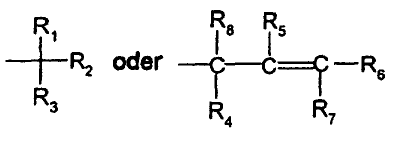 steht, wobei R₁, R₂, R₃, R₄, R₅, R₆, R₇ und R₈ die in Anspruch 1 gegebene Bedeutung haben.

8. Hochmolekulares organisches Material enthaltend in der Masse ein in situ durch thermischen Abbau einer Verbindung der Formel (1) gemäss Anspruch 1 erzeugtes Farbmittel der Formel (I) gemäss Anspruch 1, worin Z' für C₂-C₁₂Alkylen-OH, C₂C₁₂Alkylen-SH oder C₂C₁₂Alkylen-NH₂ steht.

9. Thermo-, photo- oder chemosensitives Aufzeichnungsmaterial, Tinte für den Tintenstrahldruck, Toner für elektrophotographische Aufzeichnungsverfahren, Farbband für den thermischen Transferdruck oder lichtempfindliche negative oder positive Resist-Zusammensetzung, **dadurch gekennzeichnet, dass** sie eine Verbindung der Formel (I) gemäss Anspruch 1 enthält.

10. Verfahren zur Herstellung von strukturierten Farbbildern oder Farbfiltern, **dadurch gekennzeichnet, dass** ein positiver oder negativer Resist enthaltend ein Farbmittel der Formel (I) gemäss Anspruch 1 musterweise bestrahlt, entwickelt und thermisch behandelt wird, wobei die thermische Behandlung bei der Bestrahlung oder Entwicklung oder nachträglich erfolgen kann und die thermische Umwandlung zu einem Farbmittel der Formel (I) gemäss Anspruch 1 führt, worin Z' für C₂-C₁₂Alkylen-OH, C₂-C₁₂Alkylen-SH oder C₂-C₁₂Alkylen-NH₂ steht.

## Claims

1. A compound of formula 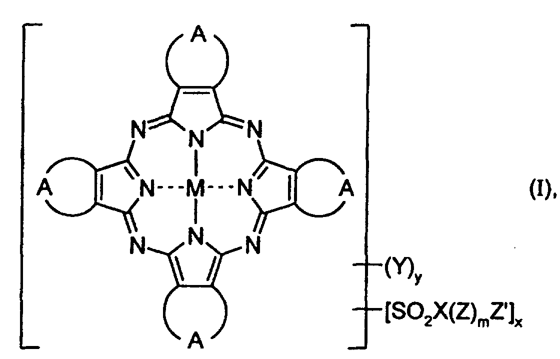 wherein
M is a divalent metal, oxo metal, halogenometal or hydroxymetal, or 2 hydrogen atoms,
A is a radical 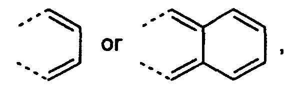 which may be unsubstituted or substituted by phenoxy, naphthyloxy, phenylthio or by naphthylthio,
X is a hetero atom selected from the group consisting of N, O and S, m being the number 0 when X is O or S and the number 1 when X is N,
Y is any desired substituent that is inert towards alkylating reagents,
Z is hydrogen, Z' or COOB,
Z' is C₂-C₁₂alkylene-N(COOB)₂, C₂-C₁₂alkylene-NHCOOB, C₂-C₁₂alkylene-OCOOB or C₂-C₁₂alkylene-SCOOB,
x is a number from 1 to 4, and y is a number from 0 to 15,
wherein the sum of x and y is a maximum of 16 and, optionally, a plurality of radicals X, Y, Z and/or Z' may be identical or different, and
B is a group of the formula 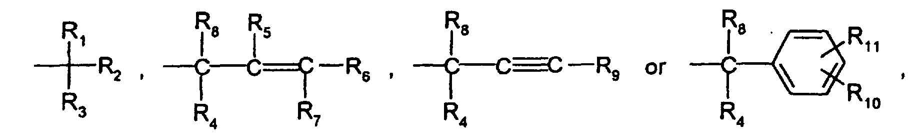
wherein
R₁ is hydrogen or C₁-C₆alkyl,
R₂ and R₃ are each independently of the other C₁-C₆alkyl,
R₄ and R₈ are each independently of the other C₁-C₆alkyl, C₁-C₆alkyl interrupted by O, S or by NR₁₂, or phenyl or biphenyl unsubstituted or substituted by C₁-C₆alkyl, C₁-C₆alkoxy, halogen, cyano or by nitro,
R₅, R₆ and R₇ are each independently of the others hydrogen or C₁-C₆alkyl,
R₉ is hydrogen, C₁-C₆alkyl or a group of the formula 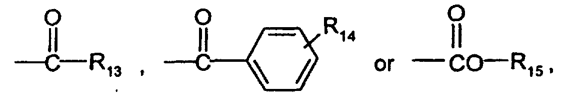
R₁₀ and R₁₁ are each independently of the other hydrogen, C₁-C₆alkyl, C₁-C₆alkoxy, halogen, cyano, nitro, N(R₁₂)₂, or phenyl unsubstituted or substituted by halogen, cyano, nitro, C₁-C₆-alkyl or by C₁-C₆alkoxy,
R₁₂ and R₁₃ are each C₁-C₆alkyl, R₁₄ is hydrogen or C₁-C₆alkyl and R₁₅ is C₁-C₆alkyl, or phenyl unsubstituted or substituted by C₁-C₆alkyl.

2. A compound according to claim 1 of formula 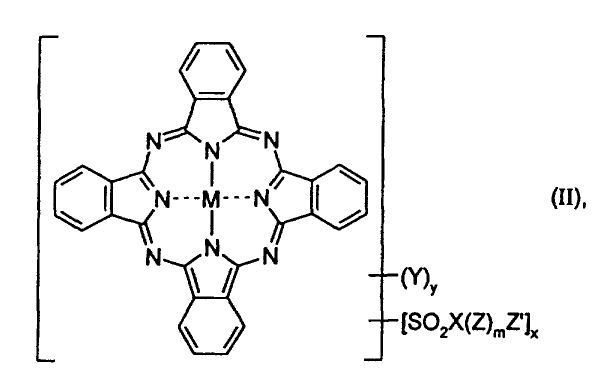 wherein Y, X, Z, Z', y, M, x and m are as defined in claim 1.

3. A compound according to claim 1, wherein M is Cu, Pd, Pb, Co, Ni, Zn, Mn or V(=O).

4. A compound according to claim 1, wherein X is N or O and Z' is C₂-C₁₂alkylene-NHCOOB or C₂-C₁₂alkylene-OCOOB.

5. A compound according to claim 1, wherein X is N, Z is COOB and Z' is C₂-C₁₂alkylene-OCOOB.

6. A compound according to claim 1, wherein Z' is C₂-C₆alkylene-N(COOB)₂, C₂-C₆alkylene-NHCOOB, C₂-C₆alkylene-OCOOB or C₂-C₆alkylene-SCOOB.

7. A compound according to claim 1, wherein B is 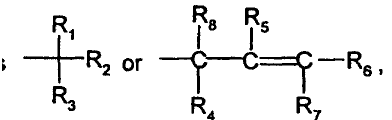 wherein R₁, R₂, R₃, R₄, R₅, R₆, R₇ and R₈ are as defined in claim 1.

8. A high molecular weight organic material comprising in the mass thereof a colourant of formula (I) according to claim 1 wherein Z' is C₂-C₁₂alkylene-OH, C₂-C₁₂alkylene-SH or C₂-C₁₂alkylene-NH₂, produced *in situ* by thermal degradation of a compound of formula (I) according to claim 1.

9. A heat-, photo- or chemo-sensitive recording material, an ink for ink-jet printing, a toner for an electrophotographic recording process, a coloured ribbon for thermal transfer printing, or a light-sensitive negative or positive resist composition that comprises a compound of formula (I).

10. A method of producing structured colour images or colour filters, which method comprises the pattern-wise irradiation, development and heat treatment of a positive or negative resist comprising a colourant of formula (I) according to claim 1, wherein the heat treatment may take place at the time of the irradiation or development or later and the thermal conversion yields a colourant of formula (I) according to claim 1 wherein Z' is C₂-C₁₂-alkylene-OH, C₂-C₁₂alkylene-SH or C₂-C₁₂alkylene-NH₂.

## Revendications

1. Composé de formule 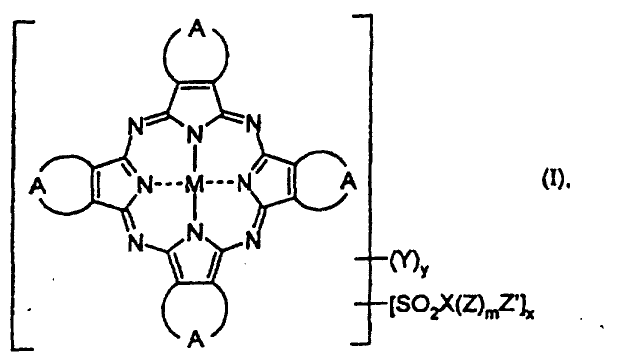
M représente un métal bivalent, un oxométal, un halogénométal ou hydroxymétal ou deux atomes d'hydrogène,
A représente un reste 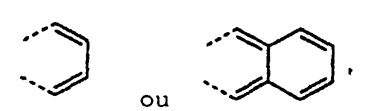 qui est non substitué ou peut être substitué par des substituants phénoxy, naphtoxy, phénylthio ou naphtylthio,
X représente un hétéroatome pris dans le groupe comprenant des atomes de N, O ou S, où lorsque X représente O ou S, m vaut 0 et lorsque X représente N, m vaut 1,
Y représente un substituant quelconque inerte vis-à-vis des réactifs d'alkylation,
Z représente un atome d'hydrogène, Z' ou COOB,
Z' représente des groupes (alkylène en C₂-C₁₂)-N(COOB)₂, (alkylène en C₂-C₁₂)-NHCOOB, (alkylène en C₂-C₁₂)-OCOOB ou (alkylène en C₂-C₁₂)-SCOOB,
x va de 1 à 4 et y va de 0 à 15,
la somme de x et y est au maximum égale à 16 et éventuellement chacun des plusieurs X, Y, Z et/ou Z' peuvent être identiques ou différents, et
B représente un groupe de formule 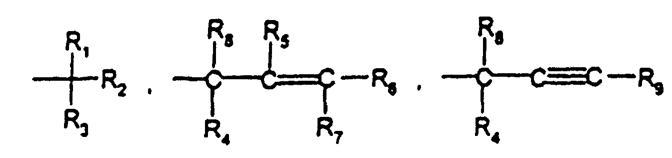 ou 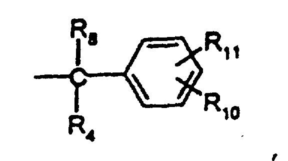 où
R₁ représente un atome d'hydrogène ou un groupe alkyle en C₁-C₆,
R₂ et R₃ représentent indépendamment l'un de l'autre un groupe alkyle en C₁-C₆,
R₄ et R₈ représentent indépendamment l'un de l'autre un groupe alkyle en C₁-C₆, alkyle en C₁-C₆ interrompu par des groupes O, S ou NR₁₂, un groupe phényle ou biphényle non substitué ou substitué par des substituants alkyle en C₁-C₆, alkoxy en C₁-C₆, halogène, cyano ou nitro,
R₅, R₆ et R₇ représentent indépendamment les uns des autres un atome d'hydrogène ou un groupe alkyle en C₁-C₆,
R₉ représente un atome d'hydrogène, un groupe alkyle en C₁-C₆ ou un groupe de formule 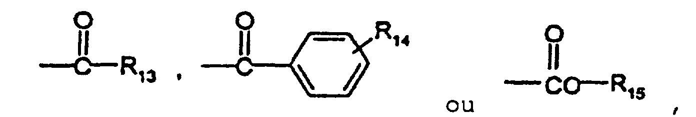
R₁₀ et R₁₁ représentent indépendamment l'un de l'autre un atome d'hydrogène, des groupes alkyle en C₁-C₆, alkoxy en C₁-C₆, halogène, cyano, nitro, N(R₁₂)₂, phényle non substitué ou substitué par des substituants halogène, cyano, nitro, alkyle en C₁-C₆ ou alkoxy en C₁-C₆,
R₁₂ et R₁₃ représentent chacun un groupe alkyle en C₁-C₆,
R₁₄ représente un atome d'hydrogène ou un groupe alkyle en C₁-C₆, et
R₁₅ représente un groupe alkyle en C₁-C₆ ou phényle non substitué ou substitué par un substituant alkyle en C₁-C₆.

2. Composé selon la revendication 1 de formule 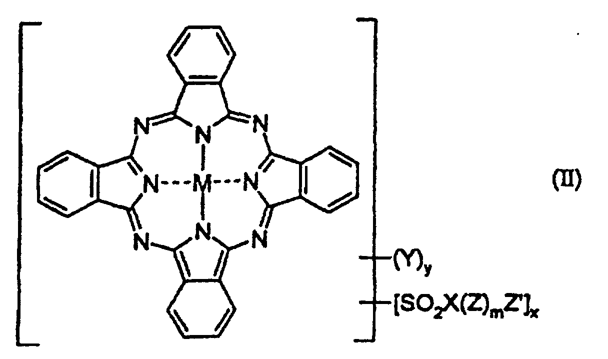 où Y, X, Z, Z', y, M, X et m possèdent la signification donnée à la revendication 1.

3. Composé selon la revendication 1, où M représente Cu, Pd, Pb, Co, Ni, Zn, Mn ou V(=O).

4. Composé selon la revendication 1, où X représente des atomes de N ou O et Z' représente un groupe (alkylène en C₂-C₁₂) NHCOOB ou (alkylène en C₂-C₁₂) OCOOB.

5. Composé selon la revendication 1, où X représente un atome de N, Z représente un groupe COOB et Z' un groupe (alkylène en C₂-C₁₂) OCOOB.

6. Composé selon la revendication 1, où Z' représente un groupe (alkylène en C₂-C₆)N(COOB)₂, (alkylène en C₂-C₆) NHCOOB, (alkylène en C₂-C₆)OCOOB ou (alkylène en C₂-C₆)SCOOB.

7. Composé selon la revendication 1, où pour B 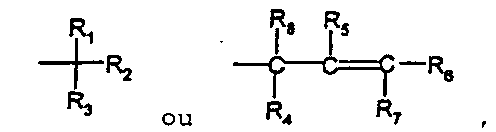 où
R₁, R₂, R₃, R₄, R₅, R₆, R₇ et R₈ possèdent la signification donnée à l'Exemple 1.

8. Matière organique de haut poids moléculaire contenant dans la masse un colorant de formule I selon la revendication 1, produit in situ par dégradation thermique d'un composé de formule (I) selon la revendication 1, où dans le colorant de formule (I) Z' représente des groupes (alkylène en C₂-C₁₂)-OH, (alkylène en C₂-C₁₂)-SH ou (alkylène en C₂-C₁₂)-NH₂.

9. Matière d'enregistrement thermo-, photo ou chimiosensible, encres pour l'impression à jet d'encre, toners pour les procédés d'enregistrement électrophotographiques, ruban coloré pour l'impression par transfert thermique ou composition de resist photosensible négative ou positive, **caractérisés en ce qu'**ils contiennent un composé de formule (I).

10. Procédé pour la préparation d'images en couleur photostructurées ou de filtres colorés, **caractérisé en ce qu'**on irradie selon modèle un resist positif ou négatif contenant un colorant de formule (I) selon la revendication 1, on le développe et on le traite par la chaleur, le traitement thermique pouvant être réalisé au cours de l'irradiation ou du développement ou ultérieurement et la transformation thermique conduit à un colorant de formule (I) selon la revendication 1, où Z' représente des groupes (alkylène en C₂-C₁₂)-OH, (alkylène en C₂-C₁₂)-SH ou (alkylène en C₂-C₁₂)-NH₂.
